(19) Europäisches Patentamt / European Patent Office / Office européen des brevets

(11) **EP 1 829 026 B1**

(12) **EUROPEAN PATENT SPECIFICATION**

(45) Date of publication and mention
of the grant of the patent:
**25.01.2017 Bulletin 2017/04**

(51) Int Cl.:
***G10L 19/008*** *(2013.01)*

(21) Application number: **05796746.5**

(22) Date of filing: **30.09.2005**

(86) International application number:
**PCT/EP2005/010595**

(87) International publication number:
**WO 2006/072270 (13.07.2006 Gazette 2006/28)**

(54) **COMPACT SIDE INFORMATION FOR PARAMETRIC CODING OF SPATIAL AUDIO**

KOMPAKTE NEBENINFORMATIONEN FÜR DIE PARAMETRISCHE CODIERUNG VON RÄUMLICHEM AUDIO

INFORMATION COMPACTE POUR LE CODAGE PARAMETRIQUE DE SIGNAL AUDIO SPATIAL

(84) Designated Contracting States:
**AT BE BG CH CY CZ DE DK EE ES FI FR GB GR HU IE IS IT LI LT LU LV MC NL PL PT RO SE SI SK TR**

(30) Priority: **10.01.2005 US 32689**

(43) Date of publication of application:
**05.09.2007 Bulletin 2007/36**

(73) Proprietors:
• **Fraunhofer-Gesellschaft zur Förderung der angewandten Forschung e.V.**
  **80686 München (DE)**
• **Agere Systems, Inc.**
  **Allentown, PA 18109 (US)**

(72) Inventors:
• **HERRE, Jürgen**
  **91054 Buckenhof (DE)**
• **FALLER, Christof**
  **8274 Tägerwilen (CH)**

(74) Representative: **Zinkler, Franz**
**Schoppe, Zimmermann, Stöckeler**
**Zinkler, Schenk & Partner mbB**
**Patentanwälte**
**Radlkoferstrasse 2**
**81373 München (DE)**

(56) References cited:
**WO-A-2004/049309**

• **"INFORMATION TECHNOLOGY - CODING OF AUDIO-VISUAL OBJECTS - PART 1: MPEG SURROUND (ISO/IEC JTC 1/SC 29/WG11 N7387)" July 2005 (2005-07), INTERNATIONAL ORGANIZATION FOR STANDARIZATION , POZNAN, POLAND , XP002370055 page 46, lines 1,2**
• **PATENT ABSTRACTS OF JAPAN vol. 1995, no. 08, 29 September 1995 (1995-09-29) & JP 07 123008 A (SONY CORP), 12 May 1995 (1995-05-12)**
• **FALLER CHRISTOF: "Parametric coding of spatial audio - Thesis No 3062" THESE PRESENTEE A LA FACULTE INFORMATIQUE ET COMMUNICATIONS INSTITUT DE SYSTEMES DE COMMUNICATION SECTION DES SYSTEMES DE COMMUNICATION ÉCOLE POLYTECHNIQUE FÉDÉRALE DE LAUSANNE POUR L'OBTENTION DU GRADE DE DOCTEUR ES SCIENCES, 2004, XP002343263 Laussane**
• **FALLER C: "Coding of spatial audio compatible with different playback formats" AUDIO ENGINEERING SOCIETY CONVENTION PAPER, NEW YORK, NY, US, 28 October 2004 (2004-10-28), pages 1-12, XP002364728 cited in the application**
• **HERRE J ET AL: "MP3 Surround: Efficient and Compatible Coding of Multi Channel Audio" AUDIO ENGINEERING SOCIETY CONVENTION PAPER, NEW YORK, NY, US, 8 May 2004 (2004-05-08), pages 1-14, XP002350798**

- **SCHUIJERS E G P ET AL: "ADVANCES IN PARAMETRIC CODING FOR HIGH-QUALITY AUDIO" IEEE BENELUX WORKSHOP ON MODEL BASED PROCESSING AND CODING OF AUDIO,, 15 November 2002 (2002-11-15), pages 73-79, XP001156065**

**Description**

## BACKGROUND OF THE INTENTION

The subject matter of this application is related to the subject matter of the following U.S. applications.

o U.S. application serial number 09/848,877, filed on 05/04/01 as attorney docket no. Faller 5;
o U.S. application serial number 10/045,458, filed on 11/07/01 as attorney docket no. Baumgarte 1-6-8, which itself claimed the benefit of the filing date of U.S. provisional application no. 60/311,565, filed on 08/10/01;
◦ U.S. application serial number 10/155,437, filed on 05/24/02 as attorney docket no. Baumgarte 2-10;
o U.S. application serial number 10/246,570, filed on 09/18/02 as attorney docket no. Baumgarte 3-11;
o U.S. application serial number 10/815,591, filed on 04/01/04 as attorney docket no. Baumgarte 7-12;
o U.S. application serial number 10/936,464, filed on 09/08/04 as attorney docket no. Baumgarte 8-7-15;
o U.S. application serial number 10/762,100, filed on 01/20/04 (Faller 13-1);
o U.S. application serial number 11/006,492, filed on 12/07/04 as attorney docket no. Allamanche 1-2-17-3; and o U.S. application serial number 11/006,xxx, filed on 12/07/04 as attorney docket no. Allamanche 2-3-18-4.

The subject matter of this application is also related to subject matter described in the following papers.

◦ F. Baumgarte and C. Faller, "Binaural Cue Coding - Part I: Psychoacoustic fundamentals and design principles," IEEE Trans. on Speech and Audio Proc., vol. 11, no. 6, Nov. 2003;
o C. Faller and F. Baumgarte, "Binaural Cue Coding - Part II: Schemes and applications," IEEE Trans. on Speech and Audio Proc., vol. 11, no. 6, Nov. 2003; and
o C. Faller, "Coding of spatial audio compatible with different playback formats," Preprint 117th Conv. Aud. Eng. Soc., October 2004.

Field of the Invention

The present invention relates to the encoding of audio signals and the subsequent synthesis of auditory scenes from the encoded audio data.

Description of the Related Art

When a person hears an audio signal (i.e., sounds) generated by a particular audio source, the audio signal will typically arrive at the person's left and right ears at two different times and with two different audio (e.g., decibel) levels, where those different times and levels are functions of the differences in the paths through which the audio signal travels to reach the left and right ears, respectively. The person's brain interprets these differences in time and level to give the person the perception that the received audio signal is being generated by an audio source located at a particular position (e.g., direction and distance) relative to the person. An auditory scene is the net effect of a person simultaneously hearing audio signals generated by one or more different audio sources located at one or more different positions relative to the person.
The existence of this processing by the brain can be used to synthesize auditory scenes, where audio signals from one or more different audio sources are purposefully modified to generate left and right audio signals that give the perception that the different audio sources are located at different positions relative to the listener.

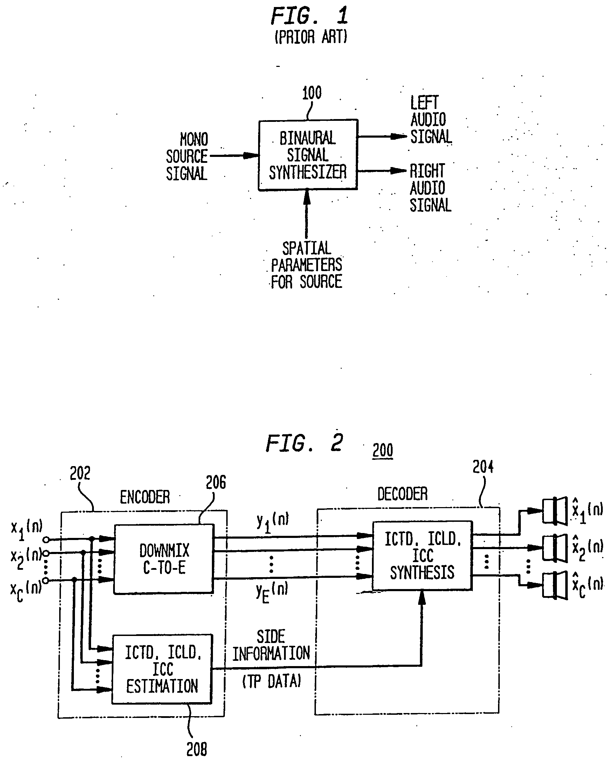

Fig. 1 shows a high-level block diagram of conventional binaural signal synthesizer 100, which converts a single audio source signal (e.g., a mono signal) into the left and right audio signals of a binaural signal, where a binaural signal is defined to be the two signals received at the eardrums of a listener. In addition to the audio source signal, synthesizer 100 receives a set of spatial cues corresponding to the desired position of the audio source relative to the listener. In typical implementations, the set of spatial cues comprises an inter-channel level difference (ICLD) value (which identifies the difference in audio level between the left and right audio signals as received at the left and right ears, respectively) and an inter-channel time difference (ICTD) value (which identifies the difference in time of arrival between the left and right audio signals as received at the left and right ears, respectively). In addition or as an alternative, some synthesis techniques involve the modeling of a direction-dependent transfer function for sound from the signal source to the eardrums, also referred to as the head-related transfer function (HRTF). See, e.g., J. Blauert, The Psychophysics of Human Sound Localization, MIT Press, 1983.
Using binaural signal synthesizer 100 of Fig. 1, the mono audio signal generated by a single sound source can be processed such that, when listened to over headphones, the sound source is spatially placed by applying an appropriate set of spatial cues (e.g., ICLD, ICTD, and/or HRTF) to generate the audio signal for each ear. See, e.g., D.R. Begault, 3-D Sound for Virtual Reality and Multimedia, Academic Press, Cambridge, MA, 1994.

Binaural signal synthesizer 100 of Fig. 1 generates the simplest type of auditory scenes: those having a single audio source positioned relative to the listener. More complex auditory scenes comprising two or more audio sources located at different positions relative to the listener can be generated using an auditory scene synthesizer that is essentially implemented using multiple instances of binaural signal synthesizer, where each binaural signal synthesizer instance generates the binaural signal corresponding to a different audio source. Since each different audio source has a different location relative to the listener, a different set of spatial cues is used to generate the binaural audio signal for each different audio source.

The PHD thesis "Parametric coding of spatial audio" from Christof Faller discloses different BCC scenarios, in which original channels are downmixed to one or a plurality of downmix channels, and where parametric side information for the original channels are calculated, transmitted to a decoder and used for upmixing the one or more downmix channels.

WO2004/049309A discloses a method of coding an audio signal, in which first parameters which feature represent an aspect of the audio signal at a first instance are calculated. Furthermore, values of second parameters which represent the aspect of the audio signal at a later instance are calculated as well. A subset of the second parameters is associated with a particular portion of a frequency range of the audio signal. This frequency range is selected to cover all frequencies present in the audio signal.

WO2005/069274A1 discloses an apparatus and method for constructing a multi-channel output signal or for generating a downmix signal, in which ICC cues and ICTD cues for both sides are calculated in an encoder. These two values can be transmitted from an encoder to a decoder. Alternatively, the encoder can compute a resulting ICC or ICTD cue by inputting the cues for both sides into a mathematical function such as an averaging function etc, for deriving the resulting value from the two coherence measures. The priority date of WO 2005/069274 A1 is earlier than the priority date of the present specification, and the publication date of WO 2005/069274 A1 is later than the priority date of the present specification.

It is an object of the present invention to provide an improved encoding/decoding concept for audio channels.

This object is achieved by a method for encoding audio channels in accordance with claim 1, an apparatus for encoding audio channels in accordance with claim 9, a machine-readable medium in accordance with claim 12, an encoded audio bit stream in accordance with claim 13, a method for decoding in accordance with claim 14, an apparatus for decoding in accordance with claim 24, or a machine-readable medium in accordance with claim 26.

## SUMMARY OF THE INVENTION

According to one embodiment, the present invention is a method, apparatus, and machine-readable medium for encoding audio channels. One or more cue codes are generated for two or more audio channels, wherein at least one cue code is a combined cue code generated by combining two or more estimated cue codes using a weighted average function considering the importance of the individual channels, and each estimated cue code is estimated from a group of two or more of the audio channels.

According to another embodiment, the present invention is an apparatus for encoding C input audio channels to generate E transmitted audio channel(s). The apparatus comprises a code estimator and a downmixer. The code estimator generates one or more cue codes for two or more audio channels, wherein at least one cue code is a combined cue code generated by combining two or more estimated cue codes using a weighted average function considering the importance of the individual channels, and each estimated cue code is estimated from a group of two or more of the audio channels. The downmixer downmixes the C input channels to generate the E transmitted channel(s), where $C>E\geq1$, wherein the apparatus is adapted to transmit information about the cue codes to enable a decoder to perform synthesis processing during decoding of the E transmitted channel(s).

According to another embodiment, the present invention is an encoded audio bitstream generated by encoding audio channels, wherein one or more cue codes are generated for two or more audio channels, wherein at least one cue code is a combined cue code generated by combining two or more estimated cue codes using a weighted average function considering the importance of the individual channels, and each estimated cue code is estimated from a group of two or more of the audio channels. The one or more cue codes and E transmitted audio channel(s) corresponding to the two or more audio channels, where $E\geq1$, are encoded into the encoded audio bitstream.

According to another embodiment, the present invention is an encoded audio bitstream comprising one or more cue codes and E transmitted audio channel(s). The one or more cue codes are generated for two or more audio channels, wherein at least one cue code is a combined cue code generated by combining two or more estimated cue codes using a weighted average function considering the importance of the individual channels, and each estimated cue code is estimated from a group of two or more of the audio channels. The E transmitted audio channel(s) correspond to the two or more audio channels

.

According to another embodiment, the present invention is a method, apparatus, and machine-readable medium for decoding E transmitted audio channel(s) to generate C playback audio channels, where $C>E\geq1$. Cue codes corresponding to the E transmitted channel(s) are received, wherein at least one cue code is a combined cue code generated by combining two or more estimated cue codes, and each estimated cue code estimated from a group of two or more audio channels corresponding to the $E$ transmitted channel(s). One or more of the E transmitted channel(s) are upmixed to generate one or more upmixed channels. One or more of the C playback channels are synthesized by applying the cue codes to the one or more upmixed channels, wherein two or more derived cue codes are derived from the combined cue code, and each derived cue code is applied to generate two or more synthesized channels.

BRIEF DESCRIPTION OF THE DRAWINGS

Other aspects, features, and advantages of the present invention will become more fully apparent from the following detailed description, the appended claims, and the accompanying drawings in which like reference numerals identify similar or identical elements.

Fig. 1 shows a high-level block diagram of conventional binaural signal synthesizer;
Fig. 2 is a block diagram of a generic binaural cue coding (BCC) audio processing system;
Fig. 3 shows a block diagram of a downmixer that can be used for the downmixer of Fig. 2;
Fig. 4 shows a block diagram of a BCC synthesizer that can be used for the decoder of Fig. 2;
Fig. 5 shows a block diagram of the BCC estimator of Fig. 2, according to one embodiment of the present invention;
Fig. 6 illustrates the generation of ICTD and ICLD data for five-channel audio;
Fig. 7 illustrates the generation of ICC data for five-channel audio;
Fig. 8 shows a block diagram of an implementation of the BCC synthesizer of Fig. 4 that can be used in a BCC decoder to generate a stereo or multi-channel audio signal given a single transmitted sum signal $s(n)$ plus the spatial cues;
Fig. 9 illustrates how ICTD and ICLD are varied within a subband as a function of frequency;
Fig. 10 shows a block diagram of a BCC synthesizer that can be used for the decoder of Fig. 2 for a 5-to-2 BCC scheme; and
Fig. 11 shows a flow diagram of the processing of a BCC system, such as that shown in Fig. 2, related to one embodiment of the present invention.

DETAILED DESCRIPTION

In binaural cue coding (BCC), an encoder encodes C input audio channels to generate $E$ transmitted audio channels, where $C>E\geq1$. In particular, two or more of the C input channels are provided in a frequency domain, and one or more cue codes are generated for each of one or more different frequency bands in the two or more input channels in the frequency domain. In addition, the $C$ input channels are downmixed to generate the E transmitted channels. In some downmixing implementations, at least one of the E transmitted channels is based on two or more of the C input channels, and at least one of the $E$ transmitted channels is based on only a single one of the C input channels.

In one embodiment, a BCC coder has two or more filter banks, a code estimator, and a downmixer. The two or more filter banks convert two or more of the C input channels from a time domain into a frequency domain. The code estimator generates one or more cue codes for each of one or more different frequency bands in the two or more converted input channels. The downmixer downmixes the C input channels to generate the E transmitted channels, where $C>E\geq1$.

In BCC decoding, E transmitted audio channels are decoded to generate C playback audio channels. In particular, for each of one or more different frequency bands, one or more of the E transmitted channels are upmixed in a frequency domain to generate two or more of the C playback channels in the frequency domain, where $C>E\geq1$. One or more cue codes are applied to each of the one or more different frequency bands in the two or more playback channels in the frequency domain to generate two or more modified channels, and the two or more modified channels are converted from the frequency domain into a time domain. In some upmixing implementations, at least one of the C playback channels is based on at least one of the E transmitted channels and at least one cue code, and at least one of the C playback channels is based on only a single one of the E transmitted channels and independent of any cue codes.

In one embodiment, a BCC decoder has an upmixer, a synthesizer, and one or more inverse filter banks. For each of one or more different frequency bands, the upmixer upmixes one or more of the E transmitted channels in a frequency domain to generate two or more of the C playback channels in the frequency domain, where $C>E\geq 1$. The synthesizer applies one or more cue codes to each of the one or more different frequency bands in the two or more playback channels in the frequency domain to generate two or more modified channels. The one or more inverse filter banks convert the two or more modified channels from the frequency domain into a time domain.

Depending on the particular implementation, a given playback channel may be based on a single transmitted channel, rather than a combination of two or more transmitted channels. For example, when there is only one transmitted channel, each of the C playback channels is based on that one transmitted channel. In these situations, upmixing corresponds to copying of the corresponding transmitted channel. As such, for applications in which there is only one transmitted channel, the upmixer may be implemented using a replicator that copies the transmitted channel for each playback channel.

BCC encoders and/or decoders may be incorporated into a number of systems or applications including, for example, digital video recorders/players, digital audio recorders/players, computers, satellite transmitters/receivers, cable transmitters/receivers, terrestrial broadcast transmitters/receivers, home entertainment systems, and movie theater systems.

Generic BCC Processing

Fig. 2 is a block diagram of a generic binaural cue coding (BCC) audio processing system 200 comprising an encoder 202 and a decoder 204. Encoder 202 includes downmixer 206 and BCC estimator 208.

Downmixer 206 converts C input audio channels $x_i(n)$ into E transmitted audio channels $y_i(n)$, where $C>E\geq1$. In this specification, signals expressed using the variable $n$ are time-domain signals, while signals expressed using the variable $k$ are frequency-domain signals. Depending on the particular implementation, downmixing can be implemented in either the time domain or the frequency domain. BCC estimator 208 generates BCC codes from the C input audio channels and transmits those BCC codes as either in-band or out-of-band side information relative to the E transmitted audio channels. Typical BCC codes include one or more of inter-channel time difference (ICTD), inter-channel level difference (ICLD), and inter-channel correlation (ICC) data estimated between certain pairs of input channels as a function of frequency and time. The particular implementation will dictate between which particular pairs of input channels, BCC codes are estimated.

ICC data corresponds to the coherence of a binaural signal, which is related to the perceived width of the audio source. The wider the audio source, the lower the coherence between the left and right channels of the resulting binaural signal. For example, the coherence of the binaural signal corresponding to an orchestra spread out over an auditorium stage is typically lower than the coherence of the binaural signal corresponding to a single violin playing solo. In general, an audio signal with lower coherence is usually perceived as more spread out in auditory space. As such, ICC data is typically related to the apparent source width and degree of listener envelopment. See, e.g., J. Blauert, The Psychophysics of Human Sound Localization, MIT Press, 1983.

Depending on the particular application, the E transmitted audio channels and corresponding BCC codes may be transmitted directly to decoder 204 or stored in some suitable type of storage device for subsequent access by decoder 204. Depending on the situation, the term "transmitting" may refer to either direct transmission to a decoder or storage for subsequent provision to a decoder. In either case, decoder 204 receives the transmitted audio channels and side information and performs upmixing and BCC synthesis using the BCC codes to convert the E transmitted audio channels into more than E (typically, but not necessarily, C) playback audio channels $\hat{x}_i(n)$ for audio playback. Depending on the particular implementation, upmixing can be performed in either the time domain or the frequency domain.

In addition to the BCC processing shown in Fig. 2, a generic BCC audio processing system may include additional encoding and decoding stages to further compress the audio signals at the encoder and then decompress the audio signals at the decoder, respectively. These audio codecs may be based on conventional audio compression/decompression techniques such as those based on pulse code modulation (PCM), differential PCM (DPCM), or adaptive DPCM (ADPCM).

When downmixer 206 generates a single sum signal (i.e., $E$=1), BCC coding is able to represent multi-channel audio signals at a bitrate only slightly higher than what is required to represent a mono audio signal. This is so, because the estimated ICTD, ICLD, and ICC data between a channel pair contain about two orders of magnitude less information than an audio waveform.

Not only the low bitrate of BCC coding, but also its backwards compatibility aspect is of interest. A single transmitted sum signal corresponds to a mono downmix of the original stereo or multi-channel signal. For receivers that do not support stereo or multi-channel sound reproduction, listening to the transmitted sum signal is a valid method of presenting the audio material on low-profile mono reproduction equipment. BCC coding can therefore also be used to enhance existing services involving the delivery of mono audio material towards multi-channel audio. For example, existing mono audio radio broadcasting systems can be enhanced for stereo or multi-channel playback if the BCC side information can be embedded into the existing transmission channel. Analogous capabilities exist when downmixing multi-channel audio to two sum signals that correspond to stereo audio.

BCC processes audio signals with a certain time and frequency resolution. The frequency resolution used is largely motivated by the frequency resolution of the human auditory system. Psychoacoustics suggests that spatial perception is most likely based on a critical band representation of the acoustic input signal. This frequency resolution is considered by using an invertible filterbank (e.g., based on a fast Fourier transform (FFT) or a quadrature mirror filter (QMF)) with subbands with bandwidths equal or proportional to the critical bandwidth of the human auditory system.

Generic Downmixing

In preferred implementations, the transmitted sum signal(s) contain all signal components of the input audio signal. The goal is that each signal component is fully maintained. Simply summation of the audio input channels often results in amplification or attenuation of signal components. In other words, the power of the signal components in a "simple" sum is often larger or smaller than the sum of the power of the corresponding signal component of each channel. A downmixing technique can be used that equalizes the sum signal such that the power of signal components in the sum signal is approximately the same as the corresponding power in all input channels.

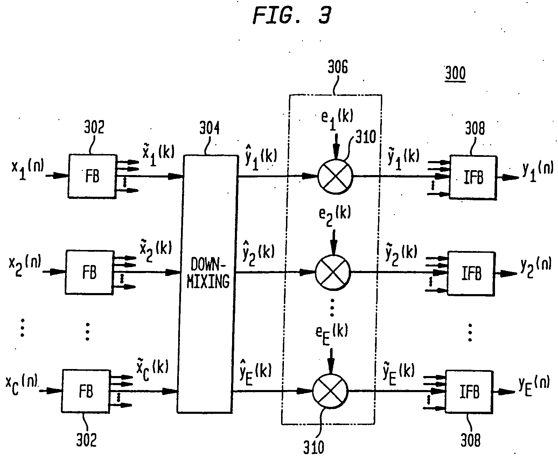

Fig. 3 shows a block diagram of a downmixer 300 that can be used for downmixer 206 of Fig. 2 according to certain implementations of BCC system 200. Downmixer 300 has a filter bank (FB) 302 for each input channel $x_i(n)$, a downmixing block 304, an optional scaling/delay block 306, and an inverse FB (IFB) 308 for each encoded channel $y_i(n)$.

Each filter bank 302 converts each frame (e.g., 20 msec) of a corresponding digital input channel $x_i(n)$ in the time domain into a set of input coefficients $\tilde{x}_i(k)$ in the frequency domain. Downmixing block 304 downmixes each sub-band of C corresponding input coefficients into a corresponding sub-band of E downmixed frequency-domain coefficients. Equation (1) represents the downmixing of the kth sub-band of input coefficients $(\tilde{x}_1(k), \tilde{x}_2(k),..., \tilde{x}_C(k))$ to generate the kth sub-band of downmixed coefficients $(\hat{y}_1(k), \hat{y}_2(k),...,\hat{y}_E(k))$ as follows:

$$\begin{bmatrix} \hat{y}_1(k) \\ \hat{y}_2(k) \\ \vdots \\ \hat{y}_E(k) \end{bmatrix} = \mathbf{D}_{CE} \begin{bmatrix} \tilde{x}_1(k) \\ \tilde{x}_2(k) \\ \vdots \\ \tilde{x}_C(k) \end{bmatrix}, \qquad (1)$$

where $\mathbf{D}_{CE}$ is a real-valued C-by-E downmixing matrix.

Optional scaling/delay block 306 comprises a set of multipliers 310, each of which multiplies a corresponding downmixed coefficient $\hat{y}_i(k)$ by a scaling factor $e_i(k)$ to generate a corresponding scaled coefficient $\tilde{y}_i(k)$. The motivation for the scaling operation is equivalent to equalization generalized for downmixing with arbitrary weighting factors for each channel. If the input channels are independent, then the power $p_{\tilde{y}_i}(k)$ of the downmixed signal in each sub-band is given by Equation (2) as follows:

$$\begin{bmatrix} p_{\tilde{y}_1(k)} \\ p_{\tilde{y}_2(k)} \\ \vdots \\ p_{\tilde{y}_E(k)} \end{bmatrix} = \overline{\mathbf{D}}_{CE} \begin{bmatrix} p_{\tilde{x}_1(k)} \\ p_{\tilde{x}_2(k)} \\ \vdots \\ p_{\tilde{x}_C(k)} \end{bmatrix}, \qquad (2)$$

where $\overline{\mathbf{D}}_{CE}$ is derived by squaring each matrix element in the C-by-E downmixing matrix $\mathbf{D}_{CE}$ and $p_{\tilde{x}_{i(k)}}$ is the power of sub-band k of input channel i.

If the sub-bands are not independent, then the power values $p_{\tilde{y}_{i(k)}}$ of the downmixed signal will be larger or smaller than that computed using Equation (2), due to signal amplifications or cancellations when signal components are in-phase or out-of-phase, respectively. To prevent this, the downmixing operation of Equation (1) is applied in sub-bands followed by the scaling operation of multipliers 310. The scaling factors $e_i(k)$ $(1 \leq i \leq E)$ can be derived using Equation (3) as follows:

$$e_i(k) = \sqrt{\frac{p_{\tilde{y}_i(k)}}{p_{\hat{y}_i(k)}}}, \qquad (3)$$

where $p_{\tilde{y}_i(k)}$ is the sub-band power as computed by Equation (2), and $p_{\hat{\tilde{y}}_i(k)}$ is power of the corresponding downmixed sub-band signal $\hat{\tilde{y}}_i(k)$.

In addition to or instead of providing optional scaling, scaling/delay block 306 may optionally apply delays to the signals.

Each inverse filter bank 308 converts a set of corresponding scaled coefficients $\tilde{y}_i(k)$ in the frequency domain into a frame of a corresponding digital, transmitted channel $y_i(n)$.

Although Fig. 3 shows all C of the input channels being converted into the frequency domain for subsequent downmixing, in alternative implementations, one or more (but less than C-1) of the C input channels might bypass some or all of the processing shown in Fig. 3 and be transmitted as an equivalent number of unmodified audio channels. Depending on the particular implementation, these unmodified audio channels might or might not be used by BCC estimator 208 of Fig. 2 in generating the transmitted BCC codes.

In an implementation of downmixer 300 that generates a single sum signal $y(n)$, E=1 and the signals $\tilde{x}_c(k)$, $(k)$ of each subband of each input channel c are added and then multiplied with a factor $e(k)$, according to Equation (4) as follows:

$$\tilde{y}(k) = e(k)\sum_{c=1}^{C} \tilde{x}_c(k). \qquad (4)$$

the factor $e(k)$ is given by Equation (5) as follows:

$$e(k) = \sqrt{\frac{\sum_{c=1}^{C} p_{\tilde{x}_c}(k)}{p_{\tilde{x}}(k)}}, \qquad (5)$$

where $p_{\tilde{x}_c}(k)$ is a short-time estimate of the power of $\tilde{x}_c(k)$ at time index $k$, and $p_{\tilde{x}}(k)$ is a short-time estimate of the power of $\sum_{c=1}^{C} \tilde{x}_c(k)$. The equalized subbands are transformed back to the time domain resulting in the sum signal $y(n)$ that is transmitted to the BCC decoder.

Generic BCC Synthesis

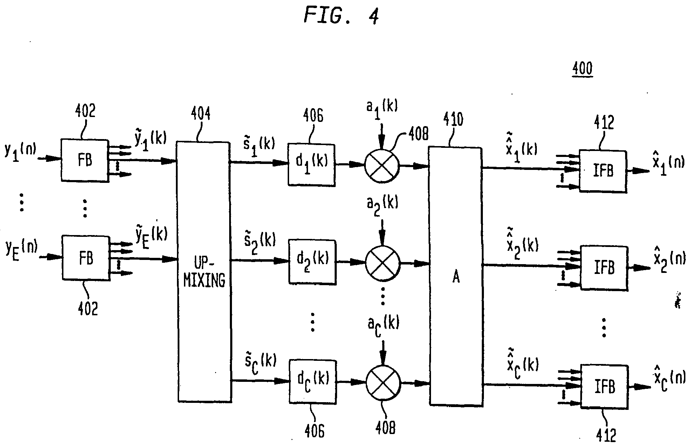

Fig. 4 shows a block diagram of a BCC synthesizer 400 that can be used for decoder 204 of Fig. 2 according to certain implementations of BCC system 200. BCC synthesizer 400 has a filter bank 402 for each transmitted channel $y_i(n)$, an upmixing block 404, delays 406, multipliers 408, correlation block 410, and an inverse filter bank 412 for each playback channel $\hat{x}_i(n)$

Each filter bank 402 converts each frame of a corresponding digital, transmitted channel $y_i(n)$ in the time domain into a set of input coefficients $\tilde{y}_i(k)$ in the frequency domain. Upmixing block 404 upmixes each sub-band of E corresponding transmitted-channel coefficients into a corresponding sub-band of C upmixed frequency-domain coefficients. Equation (4) represents the upmixing of the $k$th sub-band of transmitted-channel coefficients $(\tilde{y}_1(k), \tilde{y}_2(k),..., \tilde{y}_E(k))$ to generate the kth sub-band of upmixed coefficients $(\tilde{s}_1(k), \tilde{s}_2(k),..., \tilde{s}_C(k))$ as follows:

$$\begin{bmatrix} \tilde{s}_1(k) \\ \tilde{s}_2(k) \\ \vdots \\ \tilde{s}_C(k) \end{bmatrix} = \mathbf{U}_{EC} \begin{bmatrix} \tilde{y}_1(k) \\ \tilde{y}_2(k) \\ \vdots \\ \tilde{y}_E(k) \end{bmatrix}, \qquad (6)$$

where $\mathbf{U}_{EC}$. is a real-valued $E$-by-$C$ upmixing matrix. Performing upmixing in the frequency-domain enables upmixing to be applied individually in each different sub-band.

Each delay **406** applies a delay value $d_i(k)$ based on a corresponding BCC code for ICTD data to ensure that the desired ICTD values appear between certain pairs of playback channels. Each multiplier 408 applies a scaling factor $a_i(k)$ based on a corresponding BCC code for ICLD data to ensure that the desired ICLD values appear between certain pairs of playback channels. Correlation block **410** performs a decorrelation operation $A$ based on corresponding BCC codes for ICC data to ensure that the desired ICC values appear between certain pairs of playback channels. Further description of the operations of correlation block **410** can be found in U.S. Patent Application No. 10/155,437, filed on 05/24/02 as Baumgarte 2-10.

The synthesis of ICLD values may be less troublesome than the synthesis of ICTD and ICC values, since ICLD synthesis involves merely scaling of sub-band signals. Since ICLD cues are the most commonly used directional cues, it is usually more important that the ICLD values approximate those of the original audio signal. As such, ICLD data might be estimated between all channel pairs. The scaling factors $a_i(k)$ ($1{\leq}i{\leq}C$) for each sub-band are preferably chosen such that the sub-band power of each playback channel approximates the corresponding power of the original input audio channel.

One goal may be to apply relatively few signal modifications for synthesizing ICTD and ICC values. As such, the BCC data might not include ICTD and ICC values for all channel pairs. In that case, BCC synthesizer 400 would synthesize ICTD and ICC values only between certain channel pairs.

Each inverse filter bank **412** converts a set of corresponding synthesized coefficients $\tilde{\tilde{x}}_i(k)$ in the frequency domain into a frame of a corresponding digital, playback *channel* $\hat{x}_i(n)$.

Although Fig. 4 shows all $E$ of the transmitted channels being converted into the frequency domain for subsequent upmixing and BCC processing, in alternative implementations, one or more (but not all) of the E transmitted channels might bypass some or all of the processing shown in Fig. 4. For example, one or more of the transmitted channels may be unmodified channels that are not subjected to any upmixing. In addition to being one or more of the C playback channels, these unmodified channels, in turn, might be, but do not have to be, used as reference channels to which BCC processing is applied to synthesize one or more of the other playback channels. In either case, such unmodified channels may be subjected to delays to compensate for the processing time involved in the upmixing and/or BCC processing used to generate the rest of the playback channels.

Note that, although Fig. 4 shows C playback channels being synthesized from E transmitted channels, where C was also the number of original input channels, BCC synthesis is not limited to that number of playback channels. In general, the number of playback channels can be any number of channels, including numbers greater than or less than C and possibly even situations where the number of playback channels is equal to or less than the number of transmitted channels.

"Perceptually relevant differences" between audio channels

Assuming a single sum signal, BCC synthesizes a stereo or multi-channel audio signal such that ICTD, ICLD, and ICC approximate the corresponding cues of the original audio signal. In the following, the role of ICTD, ICLD, and ICC in relation to auditory spatial image attributes is discussed.

Knowledge about spatial hearing implies that for one auditory event, ICTD and ICLD are related to perceived direction. When considering binaural room impulse responses (BRIRs) of one source, there is a relationship between width of the auditory event and listener envelopment and ICC data estimated for the early and late parts of the BRIRs. However, the relationship between ICC and these properties for general signals (and not just the BRIRs) is not straightforward.

Stereo and multi-channel audio signals usually contain a complex mix of concurrently active source signals superimposed by reflected signal components resulting from recording in enclosed spaces or added by the recording engineer for artificially creating a spatial impression. Different source signals and their reflections occupy different regions in the time-frequency plane. This is reflected by ICTD, ICLD, and ICC, which vary as a function of time and frequency. In this case, the relation between instantaneous ICTD, ICLD, and ICC and auditory event directions and spatial impression is not obvious. The strategy of certain embodiments of BCC is to blindly synthesize these cues such that they approximate the corresponding cues of the original audio signal.

Filterbanks with subbands of bandwidths equal to two times the equivalent rectangular bandwidth (ERB) are used. Informal listening reveals that the audio quality of BCC does not notably improve when choosing higher frequency resolution. A lower frequency resolution may be desired, since it results in less ICTD, ICLD, and ICC values that need to be transmitted to the decoder and thus in a lower bitrate.

Regarding time resolution, ICTD, ICLD, and ICC are typically considered at regular time intervals. High performance is obtained when ICTD, ICLD, and ICC are considered about every 4 to 16 ms. Note that, unless the cues are considered at very short time intervals, the precedence effect is not directly considered. Assuming a classical lead-lag pair of sound stimuli, if the lead and lag fall into a time interval where only one set of cues is synthesized, then localization dominance of the lead is not considered. Despite this, BCC achieves audio quality reflected in an average MUSHRA score of about 87 (i.e., "excellent" audio quality) on average and up to nearly 100 for certain audio signals.

The often-achieved perceptually small difference between reference signal and synthesized signal implies that cues related to a wide range of auditory spatial image attributes are implicitly considered by synthesizing ICTD, ICLD, and ICC at regular time intervals. In the following, some arguments are given on how ICTD, ICLD, and ICC may relate to a range of auditory spatial image attributes.

Estimation of spatial cues

In the following, it is described how ICTD, ICLD, and ICC are estimated. The bitrate for transmission of these (quantized and coded) spatial cues can be just a few kb/s and thus, with BCC, it is possible to transmit stereo and multi-channel audio signals at bitrates close to what is required for a single audio channel.

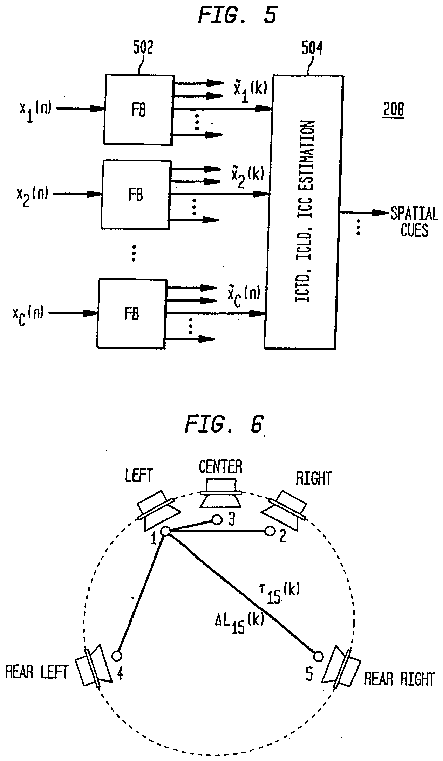

Fig. 5 shows a block diagram of BCC estimator 208 of Fig. 2, according to one embodiment of the present invention. BCC estimator 208 comprises filterbanks (FB) 502, which may be the same as filterbanks 302 of Fig. 3, and estimation block 504, which generates ICTD, ICLD, and ICC spatial cues for each different frequency subband generated by filterbanks 502.

Estimation of ICTD, ICLD, and ICC for stereo signals

The following measures are used for ICTD, ICLD, and ICC for corresponding subband signals $\tilde{x}_1(k)$ and $\tilde{x}_2(k)$ of two (e.g., stereo) audio channels:

o ICTD [samples]:

$$\tau_{12}(k) = \arg\max_d \left\{ \Phi_{12}(d,k) \right\}, \qquad (7)$$

with a short-time estimate of the normalized cross-correlation function given by Equation (8) as follows:

$$\Phi_{12}(d,k) = \frac{p_{\tilde{x}_1\tilde{x}_2}(d,k)}{\sqrt{p_{\tilde{x}_1}(k-d_1)p_{\tilde{x}_2}(k-d_2)}}, \qquad (8)$$

where

$$\begin{aligned} d_1 &= \max\{-d,0\} \\ d_2 &= \max\{d,0\} \end{aligned}, \qquad (9)$$

and $p_{\tilde{x}_1\tilde{x}_2}(d,k)$ is a short-time estimate of the mean of $\tilde{x}_1(k-d_1)\tilde{x}_2(k-d_2)$.

∘ ICLD [dB]:

$$\Delta L_{12}(k) = 10\log_{10}\left( \frac{p_{\tilde{x}_2}(k)}{p_{\tilde{x}_1}(k)} \right). \qquad (10)$$

o ICC:

$$c_{12}(k) = \max_d \left| \Phi_{12}(d,k) \right|. \qquad (11)$$

Note that the absolute value of the normalized cross-correlation is considered and $c_{12}(k)$ has a range of [0,1].

Estimation of ICTD, ICLD, and ICC for multi-channel audio signals

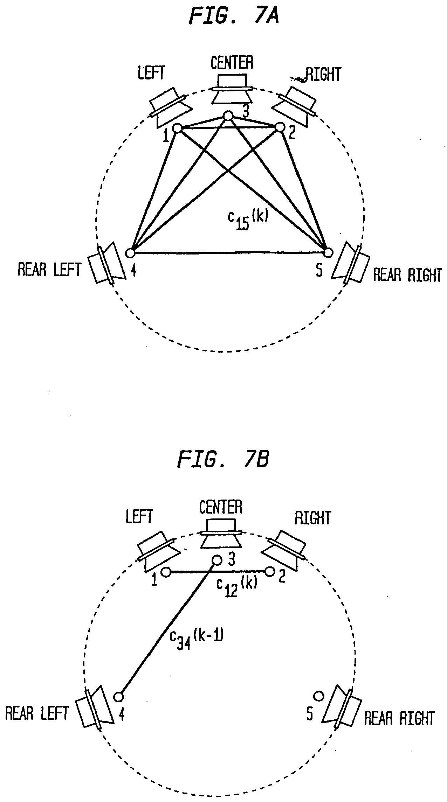

When there are more than two input channels, it is typically sufficient to define ICTD and ICLD between a reference channel (e.g., channel number 1) and the other channels, as illustrated in Fig. 6 for the case of C=5 channels. where $\tau_{1c}(k)$ and $\Delta L_{1c}(k)$ denote the ICTD and ICLD, respectively, between the reference channel 1 and channel c.
As opposed to ICTD and ICLD, ICC typically has more degrees of freedom. The ICC as defined can have different values between all possible input channel pairs. For C channels, there are $C(C-1)/2$ possible channel pairs; e.g., for 5 channels there are 10 channel pairs as illustrated in Fig. 7(a). However, such a scheme requires that, for each subband at each time index, $C(C-1)/2$ ICC values are estimated and transmitted, resulting in high computational complexity and high bitrate.
Alternatively, for each subband, ICTD and ICLD determine the direction at which the auditory event of the corresponding signal component in the subband is rendered. One single ICC parameter per subband may then be used to describe the overall coherence between all audio channels. Good results can be obtained by estimating and transmitting ICC cues only between the two channels with most energy in each subband at each time index. This is illustrated in Fig. 7(b), where for time instants $k$-1 and $k$ the channel pairs (3, 4) and (1, 2) are strongest, respectively. A heuristic rule may be used for determining ICC between the other channel pairs.

Synthesis of spatial cues

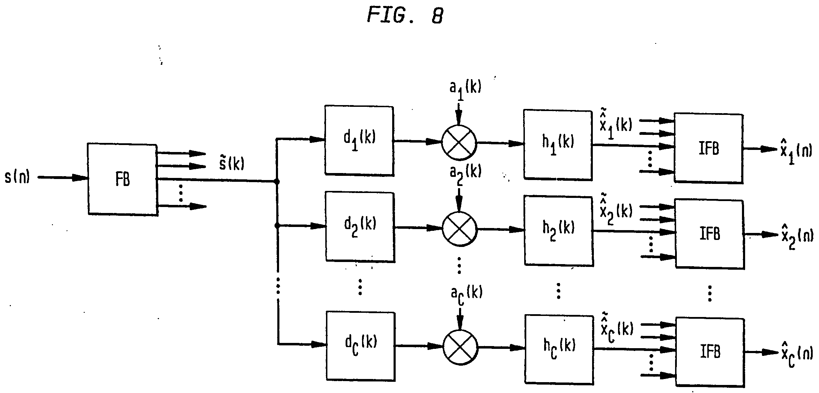

Fig. 8 shows a block diagram of an implementation of BCC synthesizer 400 of Fig. 4 that can be used in a BCC decoder to generate a stereo or multi-channel audio-signal given a single transmitted sum signal *s(n)* plus the spatial cues. The sum signal *s(n)* is decomposed into subbands, where $\tilde{s}(k)$ denotes one such subband. For generating the corresponding subbands of each of the output channels, delays $d_c$, scale factors $a_c$, and filters $h_c$ are applied to the corresponding subband of the sum signal. (For simplicity of notation, the time *index k* is ignored in the delays, scale factors, and filters.) ICTD are synthesized by imposing delays, ICLD by scaling, and ICC by applying de-correlation filters. The processing shown in Fig. 8 is applied independently to each subband.

ICTD synthesis

The delays $d_c$ are determined from the ICTDs $\tau_{1c}(k)$, according to Equation (12) as follows:

$$d_c = \begin{cases} -\dfrac{1}{2}\left(\max_{2\leq l\leq C}\tau_{1l}(k) + \min_{2\leq l\leq C}\tau_{1l}(k)\right), & c = 1 \\ \tau_{1l}(k) + d_1 & 2 \leq c \leq C. \end{cases} \qquad (12)$$

The delay for the reference channel, $d_1$, is computed such that the maximum magnitude of the delays $d_c$ is minimized. The less the subband signals are modified, the less there is a danger for artifacts to occur. If the subband sampling rate does not provide high enough time-resolution for ICTD synthesis, delays can be imposed more precisely by using suitable all-pass filters.

ICLD synthesis

In order that the output subband signals have desired ICLDs $\Delta L_{12}(k)$ between channel c and the reference channel 1, the gain factors $a_c$ should satisfy Equation (13) as follows:

$$\frac{a_c}{a_1} = 10^{\frac{\Delta L_{1c}(k)}{20}}. \qquad (13)$$

Additionally, the output subbands are preferably normalized such that the sum of the power of all output channels is equal to the power of the input sum signal. Since the total original signal power in each subband is preserved in the sum signal, this normalization results in the absolute subband power for each output channel approximating the corresponding power of the original encoder input audio signal. Given these constraints, the scale factors $a_c$ are given by Equation (14) as follows:

$$a_c = \begin{cases} 1 \Big/ \sqrt{1 + \sum_{l=2}^{C} 10^{\Delta L_{1l}/10}}, & c = 1 \\ 10^{\Delta L_{1c}/20} a_1, & \text{otherwise.} \end{cases} \qquad (14)$$

ICC synthesis

In certain embodiments, the aim of ICC synthesis is to reduce correlation between the subbands after delays and scaling have been applied, without affecting ICTD and ICLD. This can be achieved by designing the filters $h_c$ in Fig. 8 such that ICTD and ICLD are effectively varied as a function of frequency such that the average variation is zero in each subband (auditory critical band).

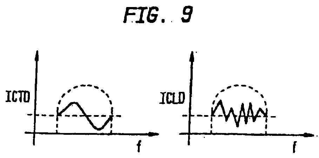

Fig. 9 illustrates how ICTD and ICLD are varied within a subband as a function of frequency. The amplitude of ICTD and ICLD variation determines the degree of de-correlation and is controlled as a function of ICC. Note that ICTD are varied smoothly (as in Fig. 9(a)), while ICLD are varied randomly. (as in Fig. 9(b)). One could vary ICLD as smoothly as ICTD, but this would result in more coloration of the resulting audio signals.

Another method for synthesizing ICC, particularly suitable for multi-channel ICC synthesis, is described in more detail in C. Faller, "Parametric multi-channel audio coding: Synthesis of coherence cues," IEEE Trans. on Speech and Audio Proc., 2003. As a function of time and frequency, specific amounts of artificial late reverberation are added to each of the output channels for achieving a desired ICC. Additionally, spectral modification can be applied such that the spectral envelope of the resulting signal approaches the spectral envelope of the original audio signal.

Other related and unrelated ICC synthesis techniques for stereo signals (or audio channel pairs) have been presented in E. Schuijers, W. Oomen, B. den Brinker, and J. Breebaart, "Advances in parametric coding for high-quality audio," in Preprint 114th Conv. Aud. Eng. Soc., Mar. 2003, and J. Engdegard, H. Purnhagen, J. Roden, and L. Liljeryd, "Synthetic ambience in parametric stereo coding," in Preprint 117th Conv. Aud. Eng. Soc., May 2004.

*C*-to-*E* BCC

As described previously, BCC can be implemented with more than one transmission channel. A variation of BCC has been described which represents C audio channels not as one single (transmitted) channel, but as *E* channels, denoted *C*-to-*E* BCC. There are (at least) two motivations for *C*-to-*E* BCC:

> o BCC with one transmission channel provides a backwards compatible path for upgrading existing mono systems for stereo or multi-channel audio playback. The upgraded systems transmit the BCC downmixer sum signal through the existing mono infrastructure, while additionally transmitting the BCC side information. *C*-to-*E* BCC is applicable to *E*-channel backwards compatible coding of *C*-channel audio.
> ○ *C*-to-*E* BCC introduces scalability in terms of different degrees of reduction of the number of transmitted channels. It is expected that the more audio channels that are transmitted, the better the audio quality will be.

Signal processing details for *C*-to-*E* BCC, such as how to define the ICTD, ICLD, and ICC cues, are described in U.S. application serial number 10/762,100, filed on 01/20/04 (Faller 13-1).

Compact Side Information

As described above, in a typical BCC scheme, the encoder transmits to the decoder ICTD, ICLD, and/or ICC codes estimated between different pairs or groups of audio channels. This side information is transmitted in addition to the (e.g., mono or stereo) downmix signal(s) in order to obtain a multi-channel audio signal after BCC decoding. Thus, it is desirable to minimize the amount of side information while not degrading subjective quality of the decoded sound.

Since ICLD and ICTD values typically relate to one reference channel, $C$-1 ICLD and ICTD values are sufficient to describe the characteristics of C encoded channels). On the other hand, ICCs are defined between arbitrary pairs of channels. As such, for C encoded channels, there are C($C$-1)/2 possible ICC pairs. For 5 encoded channels, this would correspond to 10 ICC pairs. In practice, in order to limit the amount of transmitted ICC information, only ICC information for certain pairs are transmitted.

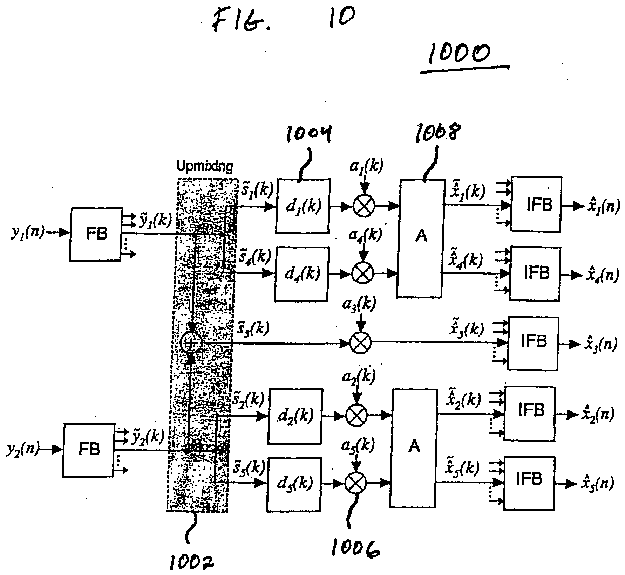

Fig. 10 shows a block diagram of a BCC synthesizer 1000 that can be used for decoder 204 of Fig. 2 for a 5-to-2 BCC scheme. As shown in Fig. 10, BCC synthesizer 1000 receives two input signals $y_1(n)$ and $y_2(n)$ and BCC side information (not shown) and generates five synthesized output signals $\hat{x}_1(n),..., \hat{x}_5(n)$, where first, second, third, fourth, and fifth output signals correspond to the left, right, center, rear left, and rear right surround signals, respectively, shown in Figs. 6 and 7.

Delay, scaling, and de-correlation parameters derived from the transmitted ICTD, ICLD, and ICC side information are applied at elements 1004, 1006, and 1008, respectively, to synthesize the five output *signals* $\hat{x}_i(n)$ from the five "upmixed" signals $\tilde{s}_i(k)$ generated by upmixing element 1002. As shown in Fig. 10, de-correlation is performed only between the left and left rear channels (i.e., channels 1 and 4) and between the right and right rear channels (i.e., channels 2 and 5). As such, no more than two sets of ICC data need to be transmitted to BCC synthesizer 1000, where those two sets characterize the ICC values between the two channel pairs for each subband. While this is already a considerable reduction in the amount of ICC side information, a further reduction is desirable.

According to one embodiment of the present invention, in the context of the 5-to-2 BCC scheme of Fig. 10, for each subband, the corresponding BCC encoder combines the ICC value estimated for the "left / left rear" channel pair with the ICC value estimated for the "right / right rear" channel pair to generate a single, combined ICC value that effectively indicates a global amount of front/back de-correlation and which is transmitted to the BCC decoder as the ICC side information. Informal experiments indicated that this simplification results in virtually no loss in audio quality, while reducing transmitted ICC information by a factor of two.

In general, embodiments of the present invention are directed to BCC schemes in which two or more different ICCs estimated between different channel pairs, or groups of channels, are combined for transmission, as indicated by Equation (15) as follows:

$$ICC_{transmitted} = f(ICC_1, ICC_2, \ldots, ICC_N), \qquad (15)$$

where $f$ is a function that combines $N$ different ICCs.

In order to obtain a combined ICC measure that is representative of the spatial image, it may be advantageous to use a weighted average for function $f$ that considers the importance of the individual channels, where channel importance may be based on the channel powers, as represented by Equation (16) as follows:

$$ICC_{transmitted} = \frac{\sum_{i=1}^{N} p_i ICC_i}{\sum_{i=1}^{N} p_i}, \qquad (16)$$

where $p_i$ is the power of the corresponding channel pair in the subband. In this case, ICCs estimated from stronger channel pairs are weighted more than ICCs estimated from weaker channel pairs. The combined power $p_i$ of a channel pair may be computed as the sum of the individual channel powers for each subband.

In the decoder, given $ICC_{transmitted}$, ICCs may be derived for each channel pair. In one possible implementation, the decoder simply uses $ICC_{transmitted}$ as the derived ICC code for each channel pair. For example, in the context of the 5-to-2 BCC scheme of Fig. 10, $ICC_{transmitted}$ can be used directly for the de-correlation of both the left / left rear channel pair and the right / right rear channel pair.

In another possible implementation, if the decoder estimates channel pair powers from the synthesized signals, then the weighting of Equation (16) can be estimated and the decoder process can optionally use this information and other perceptual and signal statistics arguments for generating a rule for deriving two individual, perceptually optimized ICC codes.

Although the combination of ICC values has been described in the context of a particular 5-to-2 BCC scheme, the present invention can be implemented in the context of any *C*-to-*E* BCC scheme, including those in which *E*=1.

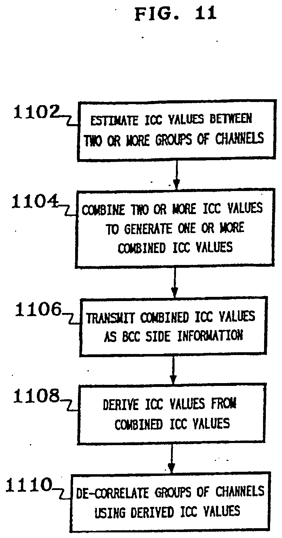

Fig. 11 shows a flow diagram of the processing of a BCC system, such as that shown in Fig. 2, related to one embodiment of the present invention. Fig. 11 shows only those steps associated with ICC-related processing.

In particular, a BCC encoder estimates ICC values between two or more groups of channels (step 1102), combines two or more of those estimated ICC values to generate one or more combined ICC values (step 1104), and transmits the combined ICC values (possibly along with one or more "uncombined" ICC values) as BCC side information to a BCC decoder (step 1106). The BCC decoder derives two or more ICC values from the received, combined ICC values (step 1108) and de-correlates groups of channels using the derived ICC values (and possibly one or more received, uncombined ICC values) (step **1110).**

Further Alternative Embodiments

The present invention has been described in the context of the 5-to-2 BCC scheme of Fig. 10. In that example, a BCC encoder (1) estimates two ICC codes for two channel pairs consisting of four different channels (i.e., left / left rear and right / right rear) and (2) averages those two ICC codes to generate a combined ICC code, which is transmitted to a BCC decoder. The BCC decoder (1) derives two ICC codes from the transmitted, combined ICC code (note that the combined ICC code may simply be used for both of the derived ICC codes) and (2) applies each of the two derived ICC codes to a different pair of synthesized channels to generate four de-correlated channels (i.e., synthesized left, left rear, right, and right rear channels).

The present invention can also be implemented in other contexts. For example, a BCC encoder could estimate two ICC codes from three input channels A, B, and C, where one estimated ICC code corresponds to channels A and B, and the other estimated ICC code corresponds to channels A and C. In that case, the encoder could be said to estimate two ICC codes from two pairs of input channels, where the two pairs of input channels share a common channel (i.e., input channel A). The encoder could then generate and transmit a single, combined ICC code based on the two estimated ICC codes. A BCC decoder could then derive two ICC codes from the transmitted, combined ICC code and apply those two derived ICC codes to synthesize three de-correlated channels (i.e., synthesized channels A, B, and C). In this case, each derived ICC code may be said to be applied to generate a pair of de-correlated channels, where the two pairs of de-correlated channels share a common channel (i.e., synthesized channel A).

Although the present invention has been described in the context of BCC coding schemes that employ combined ICC codes, the present invention can also be implemented in the context of BCC coding schemes that employ combined BCC cue codes that are generated by combining two or more BCC cue codes other than ICC codes, such as ICTD codes and/or ICLD codes, instead of or in addition to employing combined ICC codes.

Although the present invention has been described in the context of BCC coding schemes involving ICTD, ICLD, and ICC codes, the present invention can also be implemented in the context of other BCC coding schemes involving only one or two of these three types of codes (e.g., ICLD and ICC, but not ICTD) and/or one or more additional types of codes.

In the 5-to-2 BCC scheme represented in Fig. 10, the two transmitted channels $y_1(n)$ and $y_2(n)$ are typically generated by applying a particular one-stage downmixing scheme to the five channels shown in Figs. 6 and 7, where channel $y_1$ is generated as a weighted sum of channels 1, 3, and 4, and channel $y_2$ is generated as a weighted sum of channels 2, 3, and 5, where, for example, in each weighted sum, the weight factor for channel 3 is one half of the weight factor used for each of the two other channels. In this one-stage BCC scheme, the estimated BCC cue codes correspond to different pairs of the original five input channels. For example, one set of estimated ICC codes is based on channels 1 and 4 and another set of estimated ICC codes is based on channels 2 and 5.

In an alternative, multi-stage BCC scheme, channels are downmixed sequentially, with BCC cue codes potentially corresponding to different groups of channels at each stage in the downmixing sequence. For example, for the five channels in Figs. 6 and 7, at a BCC encoder, the original left and rear left channels could be downmixed to form a first-downmixed left channel with a first set of BCC cue codes generated corresponding to those two original channels. Similarly, the original right and right rear channels could be downmixed to form a first-downmixed right channel with a second set of BCC cue codes generated corresponding to those two original channels. In a second downmixing stage, the first-downmixed left channel could be downmixed with the original center channel to form a second-downmixed left channel with a third set of BCC cue codes generated corresponding to the first-downmixed left channel and the original center channel. Similarly, the first-downmixed right channel could be downmixed with the original center channel to form a second-downmixed right channel with a fourth set of BCC cue codes generated corresponding to the first-downmixed right channel and the original center channel. The second-downmixed left and right channels could then be transmitted with all four sets of BCC cue codes as the side information. In an analogous manner, a corresponding BCC decoder could then sequentially apply these four sets of BCC cue codes at different stages of a two-stage, sequential upmixing scheme to synthesize five output channels from the two transmitted "stereo" channels.

Although the present invention has been described in the context of BCC coding schemes in which combined ICC cue codes are transmitted with one or more audio channels (i.e., the E transmitted channels) along with other BCC codes, in alternative embodiments, the combined ICC cue codes could be transmitted, either alone or with other BCC codes, to a place (e.g., a decoder or a storage device) that already has the transmitted channels and possibly other BCC codes.

Although the present invention has been described in the context of BCC coding schemes, the present invention can also be implemented in the context of other audio processing systems in which audio signals are de-correlated or other audio processing that needs to de-correlate signals.

Although the present invention has been described in the context of implementations in which the encoder receives input audio signal in the time domain and generates transmitted audio signals in the time domain and the decoder receives the transmitted audio signals in the time domain and generates playback audio signals in the time domain, the present invention is not so limited. For example, in other implementations, any one or more of the input, transmitted, and playback audio signals could be represented in a frequency domain.

BCC encoders and/or decoders may be used in conjunction with or incorporated into a variety of different applications or systems, including systems for television or electronic music distribution, movie theaters, broadcasting, streaming, and/or reception. These include systems for encoding/decoding transmissions via, for example, terrestrial, satellite, cable, internet, intranets, or physical media (e.g., compact discs, digital versatile discs, semiconductor chips, hard drives, memory cards, and the like). BCC encoders and/or decoders may also be employed in games and game systems, including, for example, interactive software products intended to interact with a user for entertainment (action, role play, strategy, adventure, simulations, racing, sports, arcade, card, and board games) and/or education that may be published for multiple machines, platforms, or media. Further, BCC encoders and/or decoders may be incorporated in audio recorders/players or CD-ROM/DVD systems. BCC encoders and/or decoders may also be incorporated into PC software applications that incorporate digital decoding (e.g., player, decoder) and software applications incorporating digital encoding capabilities (e.g., encoder, ripper, recoder, and jukebox).

The present invention may be implemented as circuit-based processes, including possible implementation as a single integrated circuit (such as an ASIC or an FPGA), a multi-chip module, a single card, or a multi-card circuit pack. As would be apparent to one skilled in the art, various functions of circuit elements may also be implemented as processing steps in a software program. Such software may be employed in, for example, a digital signal processor, micro-controller, or general-purpose computer.

The present invention can be embodied in the form of methods and apparatuses for practicing those methods. The present invention can also be embodied in the form of program code embodied in tangible media, such as floppy diskettes, CD-ROMs, hard drives, or any other machine-readable storage medium, wherein, when the program code is loaded into and executed by a machine, such as a computer, the machine becomes an apparatus for practicing the invention. The present invention can also be embodied in the form of program code, for example, whether stored in a storage medium, loaded into and/or executed by a machine, or transmitted over some transmission medium or carrier, such as over electrical wiring or cabling, through fiber optics, or via electromagnetic radiation, wherein, when the program code is loaded into and executed by a machine, such as a computer, the machine becomes an apparatus for practicing the invention. When implemented on a general-purpose processor, the program code segments combine with the processor to provide a unique device that operates analogously to specific logic circuits.

It will be further understood that various changes in the details, materials, and arrangements of the parts which have been described and illustrated in order to explain the nature of this invention may be made by those skilled in the art without departing from the scope of the invention as expressed in the following claims.

Although the steps in the following method claims, if any, are recited in a particular sequence with corresponding labeling, unless the claim recitations otherwise imply a particular sequence for implementing some or all of those steps, those steps are not necessarily intended to be limited to being implemented in that particular sequence.

**Claims**

1. A method for encoding audio channels, the method comprising:

   generating (1102, 1104) one or more cue codes to be transmitted for two or more audio channels, wherein:

   at least one cue code of the cue codes to be transmitted is a combined cue code generated by combining (1104) two or more estimated cue codes using a weighted average function, the weighted average function considering the importance of the individual channels ; and
   each estimated cue code is estimated from a different group of two or more of the audio channels; and

   transmitting (1106) or storing the one or more cue codes to be transmitted.

2. The method of claim 1, further comprising transmitting E transmitted audio channel(s) corresponding to the two or more audio channels, where $E \leq 1$.

3. The method of claim 2, wherein:

   the two or more audio channels comprise C input audio channel(s), where $C > E$; and the C input channels are downmixed to generate the E transmitted channel(s).

4. The method of claim 1, wherein the one or more cue codes to be transmitted are transmitted to enable a decoder to perform synthesis processing during decoding of E transmitted channel(s) based on the combined cue code, wherein the E transmitted audio channel(s) correspond to the two or more audio channels, where $E \leq 1$.

5. The method of claim 1, wherein the one or more cue codes to be transmitted comprise one or more of a combined inter-channel correlation (ICC) code, a combined inter-channel level difference (ICLD) code, and a combined inter-channel time difference (ICTD) code.

6. The method of claim 1, wherein:

   each estimated cue code used to generate the combined cue code is associated with a weight factor used in generating the weighted average; and
   the weight factor for each estimated cue code is based on power in the group of channels corresponding to the estimated cue code.

7. The method of claim 1, wherein the combined cue code is a combined ICC code.

8. The method of claim 7, wherein:

   the two or more audio channels comprise a left channel, a left rear channel, a right channel, and a right rear channel;
   a first estimated ICC code is generated from the left and left rear channels;
   a second estimated ICC code is generated from the right and right rear channels; and
   the combined ICC code is generated by combining the first and second estimated ICC codes.

9. Apparatus (202) for encoding audio channels, the apparatus comprising:

   means (208) for generating one or more cue codes to be transmitted for two or more audio channels, wherein:

      at least one cue code of the one or more cue codes to be transmitted is a combined cue code generated by combining two or more estimated cue codes using a weighted average function, the weighted average function considering the importance of the individual channels; and
      each estimated cue code is estimated from a different group of two or more of the audio channels; and

   means for transmitting or storing the one or more cue codes to be transmitted.

10. Apparatus of claim 9,
    wherein the apparatus is for encoding C input audio channels to generate E transmitted audio channel(s) :

    wherein the means for generating includes a code estimator,

    wherein the apparatus additionally comprises a downmixer (206) 25 adapted to downmix the C input channels to generate the E transmitted channel(s), where $C > E \geq 1$, and
    wherein the apparatus is adapted to transmit information about the one or more cue codes to be transmitted to enable a decoder to perform synthesis processing during decoding of the E transmitted channel(s).

11. The apparatus of claim 10, wherein:

    the apparatus is a system selected from the group consisting of a digital video recorder, a digital audio recorder, a computer, a satellite transmitter, a cable transmitter, a terrestrial broadcast transmitter, a home entertainment system, and a movie theater system; and
    the system comprises the code estimator and the downmixer.

12. A machine-readable medium, having encoded thereon program code, wherein, when the program code is executed by a machine, the machine implements a method for encoding audio channels, the method comprising:

    generating (1102, 1104) one or more cue codes to be transmitted for two or more audio channels, wherein:

       at least one cue code of the one or more cue codes to be transmitted is a combined cue code generated by combining (1104) two or more estimated cue codes using a weighted average function, the weighted average function considering the importance of the individual channels; and
each estimated cue code is estimated from a different group of two or more of the audio channels; and

transmitting (1106) or storing the one or more cue codes to be transmitted.

13. An encoded audio bitstream generated by encoding audio channels, wherein:

one or more cue codes to be transmitted are generated for two or more audio channels, wherein:

at least one cue code of the one or more cue codes to be transmitted is a combined cue code generated by combining two or more estimated cue codes using a weighted average function, the weighted average function considering the importance of the individual channels; and
each estimated cue code is estimated from a different group of two or more of the audio channels; and

wherein the one or more cue codes to be transmitted and E transmitted audio channel(s) corresponding to the two or more audio channels, where $E \geq 1$, are encoded into the encoded audio bitstream.

14. A method for decoding E transmitted audio channel(s) to generate C playback audio channels, where $C > E \geq 1$, the method comprising:

receiving cue codes corresponding to the E transmitted channel(s), wherein:

at least one cue code of the received cue codes is a combined cue code generated by combining two or more estimated cue codes; and
each estimated cue code estimated from a different group of two or more encoder input audio channels;

upmixing one or more of the E transmitted channel(s) to generate one or more upmixed channels; and
synthesizing one or more of the C playback channels by applying the received cue codes to the one or more upmixed channels, wherein:

two or more derived cue codes are derived from the combined cue code (1108); and
each derived cue code is applied (1110) to generate two or
more synthesized channels.

15. The method of claim 14, wherein the received cue codes comprise one or more of a combined ICC code, a combined ICLD code, and a combined ICTD code.

16. The method of claim 14, wherein the combined cue code is an average of the two or more estimated cue codes.

17. The method of claim 16, wherein the combined cue code is a weighted average of the two or more estimated cue codes.

18. The method of claim 17, wherein:

each estimated cue code used to generate the combined cue code is associated with a weight factor used in generating the weighted average; and
the weight factor for each estimated cue code is based on power in the group of channels corresponding to the estimated cue code.

19. The method of claim 14, wherein the two or more derived cue codes are derived by:

deriving a weight factor for each group of two or more channels associated with an estimated cue code; and
deriving the two or more derived cue codes as a function of the combined cue code and two or more derived weight factors.

20. The method of claim 19, wherein each derived weight factor is derived by:

estimating power in the group of channels corresponding to an estimated cue code; and
deriving the weight factor based an the estimated powers for different groups of channels corresponding to different estimated cue codes.

21. The method of claim 14, wherein the combined cue code is a combined ICC code.

22. The method of claim 21, wherein:

the two or more audio channels comprise a left channel, a left rear channel, a right channel, and a right rear channel;
a first estimated ICC code is generated from the left and left rear channels;
a second estimated ICC code is generated from the right and right rear channels; and
the combined ICC code is generated by combining the first and second estimated ICC codes.

23. The method of Claim 22, wherein:

the combined ICC code is used to de-correlate synthesized left and left rear channels; and
the combined ICC code is used to de-correlate synthesized right and right rear channels.

24. Apparatus (204) for decoding E transmitted audio channel(s)
to generate C playback audio channels, where C > E ≥ 1, the apparatus comprising:

means for receiving cue codes corresponding to the E transmitted channel(s), wherein:

at least one cue code of the received cue codes is a combined cue code generated by combining two or more estimated cue codes; and
each estimated cue code estimated from a different group of two or more encoder input audio channels;

means for upmixing one or more of the E transmitted channel(s) to generate one or more upmixed channels; and
means for synthesizing one or more of the C playback channels by applying the received cue codes to the one or more upmixed channels, wherein:

two or more derived cue codes are derived from the combined cue code; and
each derived cue code is applied to generate two or more synthesized channels.

25. The apparatus of claim 24, wherein:

the apparatus is a system selected from the group consisting of a digital video player, a digital audio player, a computer, a satellite receiver, a cable receiver, a terrestrial broadcast receiver, a home entertainment system, and a movie theater system; and
the system comprises the receiver, the upmixer, and the synthesizer.

26. A machine-readable medium, having encoded thereon program code, wherein, when the program code is executed by a machine, the machine implements a method for decoding E transmitted audio channel(s) to generate C playback audio channels, where C > E ≥ 1, the method comprising:

receiving cue codes corresponding to the E transmitted channel(s), wherein:

at least one cue code of the received cue code is a combined cue code generated by combining two or more estimated cue codes; and
each estimated cue code estimated from a different group of two or more encoder input audio channels;

upmixing one or more of the E transmitted channel(s) to generate one or more upmixed channels; and
synthesizing one or more of the C playback channels by applying the received cue codes to the one or more upmixed channels, wherein:

two or more derived cue codes are derived from the combined cue code; and
each derived cue code is applied to generate two or more synthesized channels.

**Patentansprüche**

1. Ein Verfahren zum Codieren von Audiokanälen, wobei das Verfahren folgende Schritte aufweist:

   Erzeugen (1102, 1104) eines oder mehrerer zu sendender Hinweiscodes für zwei oder mehr Audiokanäle, wobei:

   zumindest ein Hinweiscode der zu sendenden Hinweiscodes ein kombinierter Hinweiscode ist, der erzeugt wird, indem zwei oder mehr geschätzte Hinweiscodes unter Verwendung einer Funktion eines gewichteten Mittelwerts kombiniert werden (1104), wobei die Funktion des gewichteten Mittelwerts die Bedeutung der einzelnen Kanäle berücksichtigt; und
   jeder geschätzte Hinweiscode aus einer anderen Gruppe zweier oder mehrerer der Audiokanäle geschätzt wird; und

   Senden (1106) oder Speichern des einen oder der mehreren zu sendenden Hinweiscodes.

2. Das Verfahren gemäß Anspruch 1, das ferner ein Senden eines E gesendeten Audiokanals beziehungsweise von E gesendeten Audiokanälen, der beziehungsweise die den zwei oder mehr Audiokanälen entspricht beziehungsweise entsprechen, wobei $E \leq 1$, aufweist.

3. Das Verfahren gemäß Anspruch 2, bei dem:

   die zwei oder mehr Audiokanäle einen C Eingangsaudiokanal beziehungsweise C Eingangsaudiokanäle, wobei $C > E$, aufweisen; und die C Eingangskanäle abwärtsgemischt werden, um den E gesendeten Kanal beziehungsweise die E gesendeten Kanäle zu erzeugen.

4. Das Verfahren gemäß Anspruch 1, bei dem der eine oder die mehreren zu sendenden Hinweiscodes gesendet werden, um einen Decodierer zu befähigen, während eines Decodierens eines E gesendeten Kanals beziehungsweise von E gesendeten Kanälen auf der Basis des kombinierten Hinweiscodes eine Syntheseverarbeitung durchzuführen, wobei der E gesendete Audiokanal beziehungsweise die E gesendeten Audiokanäle den zwei oder mehr Audiokanälen entspricht beziehungsweise entsprechen, wobei $E \geq 1$.

5. Das Verfahren gemäß Anspruch 1, bei dem der eine oder die mehreren zu sendenden Hinweiscodes einen oder mehrere eines kombinierten Zwischenkanal-Korrelation-Codes (ICC-Codes, ICC = inter-channel correlation), eines kombinierten Zwischenkanal-Pegeldifferenz-Codes (ICLD-Codes, ICLD = inter-channel level difference) und eines kombinierten Zwischenkanal-Zeitdifferenz-Codes (ICTD-Codes, ICTD = inter-channel time difference) aufweisen.

6. Das Verfahren gemäß Anspruch 1, bei dem:

   jeder geschätzte Hinweiscode, der zum Erzeugen des kombinierten Hinweiscodes verwendet wird, einem Gewichtungsfaktor zugeordnet wird, der beim Erzeugen des gewichteten Mittelwerts verwendet wird; und
   der Gewichtungsfaktor für jeden geschätzten Hinweiscode auf einer Leistung in der Gruppe von Kanälen, die dem geschätzten Hinweiscode entspricht, beruht.

7. Das Verfahren gemäß Anspruch 1, bei dem der kombinierte Hinweiscode ein kombinierter ICC-Code ist.

8. Das Verfahren gemäß Anspruch 7, bei dem:

   die zwei oder mehr Audiokanäle einen linken Kanal, einen linken hinteren Kanal, einen rechten Kanal und einen rechten hinteren Kanal aufweisen;
   ein erster geschätzter ICC-Code aus dem linken und dem linken hinteren Kanal erzeugt wird;
   ein zweiter geschätzter ICC-Code aus dem rechten und dem rechten hinteren Kanal erzeugt wird; und
   der kombinierte ICC-Code durch Kombinieren des ersten und des zweiten geschätzten ICC-Codes erzeugt wird.

9. Vorrichtung (202) zum Codieren von Audiokanälen, wobei die Vorrichtung folgende Merkmale aufweist:

   eine Einrichtung (208) zum Erzeugen eines oder mehrerer zu sendender Hinweiscodes für zwei oder mehr Audiokanäle, wobei:

EP 1 829 026 B1

zumindest ein Hinweiscode des einen oder der mehreren zu sendenden Hinweiscodes ein kombinierter Hinweiscode ist, der erzeugt wird, indem zwei oder mehr geschätzte Hinweiscodes unter Verwendung einer Funktion eines gewichteten Mittelwerts kombiniert werden, wobei die Funktion des gewichteten Mittelwerts die Bedeutung der einzelnen Kanäle berücksichtigt; und

jeder geschätzte Hinweiscode aus einer anderen Gruppe zweier oder mehrerer der Audiokanäle geschätzt wird; und

eine Einrichtung zum Senden oder Speichern des einen oder der mehreren zu sendenden Hinweiscodes.

**10.** Vorrichtung gemäß Anspruch 9,
wobei die Vorrichtung dazu dient, C Eingangsaudiokanäle zu codieren, um einen E gesendeten Audiokanal beziehungsweise E gesendete Audiokanäle zu erzeugen:

wobei die Einrichtung zum Erzeugen eine Codeschätzeinrichtung aufweist,
wobei die Vorrichtung zusätzlich einen Abwärtsmischer (206) umfasst, der dazu angepasst ist, die C Eingangskanäle abwärtszumischen, um den E gesendeten Kanal beziehungsweise die E gesendeten Kanäle zu erzeugen, wobei C>E≥1, und
wobei die Vorrichtung dazu angepasst ist, Information über den einen oder die mehreren zu sendenden Hinweiscodes zu senden, um einen Decodierer zu befähigen, während des Decodierens des E gesendeten Kanals beziehungsweise der E gesendeten Kanäle eine Syntheseverarbeitung durchzuführen.

**11.** Die Vorrichtung gemäß Anspruch 10, wobei:

die Vorrichtung ein System ist, das aus der Gruppe ausgewählt ist, die aus einem digitalen Videorecorder, einem digitalen Audiorecorder, einem Computer, einem Satellitensender, einem Kabelsender, einem terrestrischen Rundfunksender, einem Unterhaltungssystem und einem Kinosystem besteht; und
das System den die Codeschätzeinrichtung und den Abwärtsmischer aufweist.

**12.** Ein maschinenlesbares Medium, auf dem ein Programmcode codiert ist, bei dem dann, wenn der Programmcode durch eine Maschine ausgeführt wird, die Maschine ein Verfahren zum Codieren von Audiokanälen implementiert, wobei das Verfahren folgende Schritte aufweist:

Erzeugen (1102, 1104) eines oder mehrerer zu sendender Hinweiscodes für zwei oder mehr Audiokanäle, wobei:

zumindest ein Hinweiscode des einen oder der mehreren zu sendenden Hinweiscodes ein kombinierter Hinweiscode ist, der erzeugt wird, indem zwei oder mehr geschätzte Hinweiscodes unter Verwendung einer Funktion eines gewichteten Mittelwerts kombiniert werden (1104), wobei die Funktion des gewichteten Mittelwerts die Bedeutung der einzelnen Kanäle berücksichtigt; und
jeder geschätzte Hinweiscode aus einer anderen Gruppe zweier oder mehrerer der Audiokanäle geschätzt wird; und

Senden (1106) oder Speichern des einen oder der mehreren zu sendenden Hinweiscodes.

**13.** Ein codierter Audiobitstrom, der durch Codieren von Audiokanälen erzeugt wird, bei dem:

ein oder mehr zu sendende Hinweiscodes für zwei oder mehr Audiokanäle erzeugt sind, wobei
zumindest ein Hinweiscode des einen oder der mehreren zu sendenden Hinweiscodes ein kombinierter Hinweiscode ist, der erzeugt wird, indem zwei oder mehr geschätzte Hinweiscodes unter Verwendung einer Funktion eines gewichteten Mittelwerts kombiniert werden, wobei die Funktion des gewichteten Mittelwerts die Bedeutung der einzelnen Kanäle berücksichtigt; und
jeder geschätzte Hinweiscode aus einer anderen Gruppe zweier oder mehrerer der Audiokanäle geschätzt wird; und

wobei der eine oder die mehreren zu sendenden Hinweiscodes und der E gesendete Audiokanal beziehungsweise die E gesendeten Audiokanäle, der beziehungsweise die den zwei oder mehr Audiokanälen entspricht beziehungsweise entsprechen, wobei E≥1, zu dem codierten Audiobitstrom codiert sind.

**14.** Ein Verfahren zum Decodieren eines E gesendeten Audiokanals beziehungsweise von E gesendeten Audiokanälen,

**20**

um C Wiedergabe-Audiokanäle zu erzeugen, wobei C>E≥1, wobei das Verfahren folgende Schritte aufweist:

Empfangen von Hinweiscodes, die dem E gesendeten Kanal beziehungsweise den E gesendeten Kanälen entsprechen, wobei:

zumindest ein Hinweiscode der empfangenen Hinweiscodes ein kombinierter Hinweiscode ist, der durch Kombinieren zweier oder mehrerer geschätzter Hinweiscodes erzeugt wird; und
jeder geschätzte Hinweiscode aus einer anderen Gruppe zweier oder mehrerer Codierereingangsaudiokanäle geschätzt wird;

Aufwärtsmischen eines oder mehrerer des E gesendeten Kanals beziehungsweise der E gesendeten Kanäle, um einen oder mehr aufwärtsgemischte Kanäle zu erzeugen; und
Synthetisieren eines oder mehrerer der C Wiedergabekanäle durch Anlegen der empfangenen Hinweiscodes an den einen oder die mehreren aufwärtsgemischten Kanäle, wobei:

zwei oder mehr abgeleitete Hinweiscodes von dem kombinierten Hinweiscode abgeleitet werden (1108); und
jeder abgeleitete Hinweiscode dazu angewendet wird (1110), zwei oder mehr synthetisierte Kanäle zu erzeugen.

15. Das Verfahren gemäß Anspruch 14, bei dem die empfangenen Hinweiscodes einen oder mehrere eines kombinierten ICC-Codes, eines kombinierten ICLD-Codes und eines kombinierten ICTD-Codes aufweisen.

16. Das Verfahren gemäß Anspruch 14, bei dem der kombinierte Hinweiscode ein Mittelwert der zwei oder mehr geschätzten Hinweiscodes ist.

17. Das Verfahren gemäß Anspruch 16, bei dem der kombinierte Hinweiscode ein gewichteter Mittelwert der zwei oder mehr geschätzten Hinweiscodes ist.

18. Das Verfahren gemäß Anspruch 17, bei dem:

jeder geschätzte Hinweiscode, der zum Erzeugen des kombinierten Hinweiscodes verwendet wird, einem Gewichtungsfaktor zugeordnet wird, der beim Erzeugen des gewichteten Mittelwerts verwendet wird; und
der Gewichtungsfaktor für jeden geschätzten Hinweiscode auf einer Leistung in der Gruppe von Kanälen, die dem geschätzten Hinweiscode entspricht, beruht.

19. Das Verfahren gemäß Anspruch 14, bei dem die zwei oder mehr abgeleiteten Hinweiscodes abgeleitet werden, indem:

ein Gewichtungsfaktor für jede Gruppe zweier oder mehrerer Kanäle, die einem geschätzten Hinweiscode zugeordnet sind, abgeleitet wird; und
die zwei oder mehr abgeleiteten Hinweiscodes in Abhängigkeit von dem kombinierten Hinweiscode und zwei oder mehr abgeleiteten Gewichtungsfaktoren abgeleitet werden.

20. Das Verfahren gemäß Anspruch 19, bei dem jeder abgeleitete Gewichtungsfaktor abgeleitet wird, indem:

Leistung in der Gruppe von Kanälen, die einem geschätzten Hinweiscode entspricht, geschätzt wird; und
der Gewichtungsfaktor auf der Basis der geschätzten Leistungen für verschiedene Gruppen von Kanälen, die verschiedenen geschätzten Hinweiscodes entsprechen, abgeleitet wird.

21. Das Verfahren gemäß Anspruch 14, bei dem der kombinierte Hinweiscode ein kombinierter ICC-Code ist.

22. Das Verfahren gemäß Anspruch 21, bei dem:

die zwei oder mehr Audiokanäle einen linken Kanal, einen linken hinteren Kanal, einen rechten Kanal und einen rechten hinteren Kanal aufweisen;
ein erster geschätzter ICC-Code aus dem linken und dem linken hinteren Kanal erzeugt wird;
ein zweiter geschätzter ICC-Code aus dem rechten und dem rechten hinteren Kanal erzeugt wird; und

der kombinierte ICC-Code durch Kombinieren des ersten und des zweiten geschätzten ICC-Codes erzeugt wird.

23. Das Verfahren gemäß Anspruch 22, bei dem:

der kombinierte ICC-Code zum Dekorrelieren des synthetisierten linken und linken hinteren Kanals verwendet wird; und
der kombinierte ICC-Code zum Dekorrelieren des synthetisierten rechten und rechten hinteren Kanals verwendet wird.

24. Vorrichtung (204) zum Decodierten eines E gesendeten Audiokanals beziehungsweise von E gesendeten Audiokanälen, um C Wiedergabe-Audiokanäle zu erzeugen, wobei C>E≥1, wobei die Vorrichtung folgende Merkmale aufweist:

eine Einrichtung zum Empfangen von Hinweiscodes, die dem E gesendeten Kanal beziehungsweise den E gesendeten Kanälen entsprechen, wobei:

zumindest ein Hinweiscode der empfangenen Hinweiscodes ein kombinierter Hinweiscode ist, der durch Kombinieren zweier oder mehrerer geschätzter Hinweiscodes erzeugt wird; und
jeder geschätzte Hinweiscode aus einer anderen Gruppe zweier oder mehrerer Codierereingangsaudiokanäle geschätzt wird;

eine Einrichtung zum Aufwärtsmischen eines oder mehrerer des E gesendeten Kanals beziehungsweise der E gesendeten Kanäle, um einen oder mehr aufwärtsgemischte Kanäle zu erzeugen; und
eine Einrichtung zum Synthetisieren eines oder mehrerer der C Wiedergabekanäle durch Anlegen der empfangenen Hinweiscodes an den einen oder die mehreren aufwärtsgemischten Kanäle, wobei:

zwei oder mehr abgeleitete Hinweiscodes von dem kombinierten Hinweiscode abgeleitet werden; und
jeder abgeleitete Hinweiscode dazu angewendet wird, zwei oder mehr synthetisierte Kanäle zu erzeugen.

25. Die Vorrichtung gemäß Anspruch 24, wobei:

die Vorrichtung ein System ist, das aus der Gruppe ausgewählt ist, die aus einem digitalen Videoabspielgerät, einem digitalen Audioabspielgerät, einem Computer, einem Satellitenempfänger, einem Kabelempfänger, einem terrestrischen Rundfunkempfänger, einem Unterhaltungssystem und einem Kinosystem besteht; und
das System den Empfänger, den Aufwärtsmischer und den Synthetisierer aufweist.

26. Ein maschinenlesbares Medium, auf dem ein Programmcode codiert ist, bei dem dann, wenn der Programmcode durch eine Maschine ausgeführt wird, die Maschine ein Verfahren zum Decodieren eines E gesendeten Audiokanals beziehungsweise von E gesendeten Audiokanälen implementiert, um C Wiedergabe-Audiokanäle zu erzeugen, wobei C>E≥1, wobei das Verfahren folgende Schritte aufweist:

Empfangen von Hinweiscodes, die dem E gesendeten Kanal beziehungsweise den E gesendeten Kanälen entsprechen, wobei:

zumindest ein Hinweiscode des empfangenen Hinweiscodes ein kombinierter Hinweiscode ist, der durch Kombinieren zweier oder mehrerer geschätzter Hinweiscodes erzeugt wird; und
jeder geschätzte Hinweiscode aus einer anderen Gruppe zweier oder mehrerer Codierereingangsaudiokanäle geschätzt wird;

Aufwärtsmischen eines oder mehrerer des E gesendeten Kanals beziehungsweise der E gesendeten Kanäle, um einen oder mehr aufwärtsgemischte Kanäle zu erzeugen; und
Synthetisieren eines oder mehrerer der C Wiedergabekanäle durch Anlegen der empfangenen Hinweiscodes an den einen oder die mehreren aufwärtsgemischten Kanäle, wobei:

zwei oder mehr abgeleitete Hinweiscodes von dem kombinierten Hinweiscode abgeleitet werden; und
jeder abgeleitete Hinweiscode dazu angewendet wird, zwei oder mehr synthetisierte Kanäle zu erzeugen.

**Revendications**

1. Procédé de codage de canaux audio, le procédé comprenant le fait de:

   générer (1102, 1104) un ou plusieurs codes de repérage à transmettre pour deux ou plusieurs canaux audio, où:

   au moins un code de repérage parmi les codes de repérage à transmettre est un code de repérage combiné généré en combinant (1104) deux ou plusieurs codes de repérage estimés à l'aide d'une fonction de moyenne pondérée, la fonction de moyenne pondérée tenant compte de l'importance des canaux individuels; et
   chaque code de repérage estimé est estimé à partir d'un groupe différent de deux ou plusieurs des canaux audio; et

   transmettre (1106) ou mémoriser les un ou plusieurs codes de repérage à transmettre.

2. Procédé selon la revendication 1, comprenant par ailleurs le fait de transmettre E canal ou canaux audio transmis correspondant aux deux ou plusieurs canaux audio, où E ≤ 1.

3. Procédé selon la revendication 2, dans lequel:

   les deux ou plusieurs canaux audio comprennent C canal ou canaux audio d'entrée, où C > E; et les C canaux d'entrée sont mélangés vers le bas pour générer les E canal ou canaux transmis.

4. Procédé selon la revendication 1, dans lequel les un ou plusieurs codes de repérage à transmettre sont transmis pour permettre à un décodeur de réaliser un traitement de synthèse pendant le décodage de E canal ou canaux transmis sur base du code de repérage combiné, où les E canal ou canaux audio transmis correspondent aux deux ou plusieurs canaux audio, où E ≥ 1.

5. Procédé selon la revendication 1, dans lequel les un ou plusieurs codes de repérage à transmettre comprennent un ou plusieurs parmi un code de corrélation entre canaux (ICC) combiné, un code de différence de niveaux entre canaux (ICLD) et un code combiné de différence de temps entre canaux (ICTD) combiné.

6. Procédé selon la revendication 1, dans lequel:

   chaque code de repérage estimé utilisé pour générer le code de repérage combiné est associé à un facteur de pondération utilisé pour générer la moyenne pondérée; et
   le facteur de pondération pour chaque code de repérage estimé est basé sur l'énergie dans le groupe de canaux correspondant au code de repérage estimé.

7. Procédé selon la revendication 1, dans lequel le code de repérage combiné est un code ICC combiné.

8. Procédé selon la revendication 7, dans lequel:

   les deux ou plusieurs canaux audio comprennent un canal gauche, un canal arrière gauche, un canal droit et un canal arrière droit;
   un premier code ICC estimé est généré à partir des canaux arrière gauche et gauche;
   un deuxième code ICC estimé est généré à partir des canaux arrière droit et droit; et
   le code ICC combiné est généré en combinant les premier et deuxième codes ICC estimés.

9. Appareil (202) pour coder des canaux audio, l'appareil comprenant:

   un moyen (208) pour générer un ou plusieurs codes de repérage à transmettre pour deux ou plusieurs canaux audio, où:

   au moins un code de repérage parmi les un ou plusieurs codes de repérage à transmettre est un code de repérage combiné généré en combinant deux ou plusieurs codes de repérage estimés à l'aide d'une fonction de moyenne pondérée, la fonction de moyenne pondérée tenant compte de l'importance des canaux individuels; et

chaque code de repérage estimé est estimé à partir d'un groupe différent de deux ou plusieurs des canaux audio; et

un moyen pour transmettre ou mémoriser les un ou plusieurs codes de repérage à transmettre.

10. Appareil selon la revendication 9,
dans lequel l'appareil est destiné à coder C canaux audio d'entrée pour générer E canal ou canaux audio transmis:

dans lequel le moyen de génération comporte un estimateur de code,
dans lequel l'appareil comprend en outre un mélangeur vers le bas (206) adapté pour mélanger vers le bas les C canaux d'entrée pour générer les E canal ou canaux transmis E, où C> E ≥ 1, et
dans lequel l'appareil est adapté pour transmettre les informations relatives aux un ou plusieurs codes de repérage à transmettre pour permettre à un décodeur de réaliser un traitement de synthèse pendant le décodage des E canal ou canaux transmis.

11. Appareil selon la revendication 10, dans lequel:

l'appareil est un système sélectionné parmi le groupe composé d'un enregistreur vidéo numérique, d'un enregistreur audio numérique, d'un ordinateur, d'un émetteur par satellite, d'un émetteur par câble, d'un émetteur de radiodiffusion terrestre, d'un système de divertissement à domicile et d'un système de cinéma; et
le système comprend l'estimateur de code et le mélangeur vers le bas.

12. Support lisible par machine présentant, y codé, un code de programme, dans lequel, lorsque le code de programme est exécuté par une machine, la machine met en oeuvre un procédé pour coder des canaux audio, le procédé comprenant le fait de:

générer (1102, 1104) un ou plusieurs codes de repérage à transmettre pour deux ou plusieurs canaux audio, où:

au moins un code de repérage parmi les un ou plusieurs codes de repérage à transmettre est un code de repérage combiné généré en combinant (1104) deux ou plusieurs codes de repérage estimés à l'aide d'une fonction de moyenne pondérée, la fonction de moyenne pondérée tenant compte de l'importance des canaux individuels; et
chaque code de repérage estimé est estimé à partir d'un groupe différent de deux ou plusieurs des canaux audio; et

transmettre (1106) ou mémoriser les un ou plusieurs codes de repérage à transmettre.

13. Flux de bits audio codé généré par codage de canaux audio, dans lequel:

un ou plusieurs codes de repérage à transmettre sont générés pour deux ou plusieurs canaux audio, où:

au moins un code de repérage parmi les un ou plusieurs codes de repérage à transmettre est un code de repérage combiné généré en combinant deux ou plusieurs codes de repérage estimés à l'aide d'une fonction de moyenne pondérée, la fonction de moyenne pondérée tenant compte de l'importance des canaux individuels; et
chaque code de repérage estimé est estimé à partir d'un groupe différent de deux ou plusieurs des canaux audio; et

dans lequel les un ou plusieurs codes de repérage à transmettre et les E canal ou canaux audio transmis correspondant aux deux ou plusieurs canaux audio, où E ≥ 1, sont codés pour obtenir le flux de bits audio codé.

14. Procédé de décodage de E canal ou canaux audio transmis pour générer C canaux audio de reproduction, où C > E ≥ 1, le procédé comprenant le fait de:

recevoir des codes de repérage correspondant aux E canal ou canaux transmis, où:

au moins un code de repérage des codes de repérage reçus est un code de repérage combiné généré en combinant deux ou plusieurs codes de repérage estimés; et

chaque code de repérage estimé est estimé à partir d'un groupe différent de deux ou plusieurs canaux audio d'entrée de codeur;

mélanger vers le haut un ou plusieurs des E canal ou canaux transmis pour générer un ou plusieurs canaux mélangés vers le haut; et

synthétiser un ou plusieurs des C canaux de reproduction en appliquant les codes de repérage reçus aux un ou plusieurs canaux mélangés vers le haut, où:

deux ou plusieurs codes de repérage dérivés sont dérivés du code de repérage combiné (1108); et

chaque code de repérage dérivé est appliqué (1110) pour générer deux ou plusieurs canaux synthétisés.

15. Procédé selon la revendication 14, dans lequel les codes de repérage reçus comprennent un ou plusieurs parmi un code ICC combiné, un code ICLD combiné et un code ICTD combiné.

16. Procédé selon la revendication 14, dans lequel le code de repérage combiné est une moyenne des deux ou plusieurs codes de repérage estimés.

17. Procédé selon la revendication 16, dans lequel le code de repérage combiné est une moyenne pondérée des deux ou plusieurs codes de repérage estimés.

18. Procédé selon la revendication 17, dans lequel:

chaque code de repérage estimé utilisé pour générer le code de repérage combiné est associé à un facteur de pondération utilisé pour générer la moyenne pondérée; et

le facteur de pondération pour chaque code de repérage estimé est basé sur l'énergie dans le groupe de canaux correspondant au code de repérage estimé.

19. Procédé selon la revendication 14, dans lequel les deux ou plusieurs codes de repérage dérivés sont dérivés:

en dérivant un facteur de pondération pour chaque groupe de deux ou plusieurs canaux associés à un code de repérage estimé; et

en dérivant les deux ou plusieurs codes de repérage dérivés en fonction du code de repérage combiné et de deux ou plusieurs facteurs de pondération dérivés.

20. Procédé selon la revendication 19, dans lequel chaque facteur de pondération dérivé est obtenu:

en estimant l'énergie dans le groupe de canaux correspondant à un code de repérage estimé; et

en dérivant le facteur de pondération en fonction des énergies estimées pour différents groupes de canaux correspondant à différents codes de repérage estimés.

21. Procédé selon la revendication 14, dans lequel le code de repérage combiné est un code ICC combiné.

22. Procédé selon la revendication 21, dans lequel:

les deux ou plusieurs canaux audio comprennent un canal gauche, un canal arrière gauche, un canal droit et un canal arrière droit;

un premier code ICC estimé est généré à partir des canaux arrière gauche et gauche;

un deuxième code ICC estimé est généré à partir des canaux arrière droit et droit; et

le code ICC combiné est généré en combinant les premier et deuxième codes ICC estimés.

23. Procédé selon la revendication 22, dans lequel:

le code ICC combiné est utilisé pour décorréler les canaux gauche et arrière gauche synthétisés; et

le code ICC combiné est utilisé pour décorréler les canaux droit et arrière droit synthétisés.

24. Appareil (204) pour décoder E canal ou canaux audio transmis pour générer C canaux audio de reproduction, où $C > E \geq 1$, l'appareil comprenant:

un moyen pour recevoir les codes de repérage correspondant aux E canal ou canaux transmis, où :

au moins un code de repérage des codes de repérage reçus est un code de repérage combiné généré en combinant deux ou plusieurs codes de repérage estimés; et

chaque code de repérage estimé est estimé à partir d'un groupe différent de deux ou plusieurs canaux audio d'entrée de codeur;

un moyen pour mélanger vers le haut un ou plusieurs des E canal ou canaux transmis pour générer un ou plusieurs canaux mélangés vers le haut; et

un moyen pour synthétiser un ou plusieurs des C canaux de reproduction en appliquant les codes de repérage reçus aux un ou plusieurs canaux mélangés vers le haut, où :

deux ou plusieurs codes de repérage dérivés sont dérivés du code de repérage combiné; et

chaque code de repérage dérivé est appliqué pour générer deux ou plusieurs canaux synthétisés.

25. Appareil selon la revendication 24, dans lequel :

l'appareil est un système sélectionné parmi le groupe composé d'un lecteur vidéo numérique, d'un lecteur audio numérique, d'un ordinateur, d'un récepteur par satellite, d'un récepteur par câble, d'un récepteur de radiodiffusion terrestre, d'un système de divertissement à domicile et d'un système de cinéma; et

le système comprend le récepteur, le mélangeur vers le haut et le synthétiseur.

26. Support lisible par machine présentant, y codé, un code de programme, dans lequel, lorsque le code de programme est exécuté par une machine, la machine met en oeuvre un procédé de décodage de E canal ou canaux audio transmis, pour générer C canaux audio de reproduction, où $C > E \geq 1$, le procédé comprenant le fait de :

recevoir les codes de repérage correspondant aux E canal ou canaux transmis, où :

au moins un code de repérage du code de repérage reçu est un code de repérage combiné généré en combinant deux ou plusieurs codes de repérage estimés; et

chaque code de repérage estimé est estimé à partir d'un groupe différent de deux ou plusieurs canaux audio d'entrée de codeur;

mélanger vers le haut un ou plusieurs des E canal ou canaux transmis pour générer un ou plusieurs canaux mélangés vers le haut; et

synthétiser un ou plusieurs des C canaux de reproduction en appliquant les codes de repérage reçus aux un ou plusieurs canaux mélangés vers le haut, où :

deux ou plusieurs codes de repérage dérivés sont dérivés du code de repérage combiné; et

chaque code de repérage dérivé est appliqué pour générer deux ou plusieurs canaux synthétisés.

## FIG. 1
### (PRIOR ART)

100

MONO SOURCE SIGNAL → **BINAURAL SIGNAL SYNTHESIZER** → LEFT AUDIO SIGNAL

→ RIGHT AUDIO SIGNAL

↑ SPATIAL PARAMETERS FOR SOURCE

## FIG. 2   200

ENCODER 202   206

$x_1(n)$
$x_2(n)$
$x_C(n)$

→ **DOWNMIX C-TO-E** → $y_1(n)$ ⋮ $y_E(n)$

→ **ICTD, ICLD, ICC ESTIMATION**

208

SIDE INFORMATION (TP DATA)

DECODER 204

→ **ICTD, ICLD, ICC SYNTHESIS** → $\hat{x}_1(n)$
$\hat{x}_2(n)$
$\hat{x}_C(n)$

FIG. 3

FIG. 4

## FIG. 5

## FIG. 6

## FIG. 7A

## FIG. 7B

FIG. 8

## FIG. 9

FIG. 10

1000

FIG. 11

```
1102 ──┐  ┌─────────────────────────────┐
        └─│  ESTIMATE ICC VALUES BETWEEN │
          │ TWO OR MORE GROUPS OF CHANNELS│
          └─────────────────────────────┘
                       │
                       ▼
1104 ──┐  ┌─────────────────────────────┐
        └─│ COMBINE TWO OR MORE ICC VALUES│
          │    TO GENERATE ONE OR MORE    │
          │       COMBINED ICC VALUES     │
          └─────────────────────────────┘
                       │
                       ▼
1106 ──┐  ┌─────────────────────────────┐
        └─│  TRANSMIT COMBINED ICC VALUES │
          │   AS BCC SIDE INFORMATION     │
          └─────────────────────────────┘
                       │
                       ▼
1108 ──┐  ┌─────────────────────────────┐
        └─│   DERIVE ICC VALUES FROM      │
          │     COMBINED ICC VALUES       │
          └─────────────────────────────┘
                       │
                       ▼
1110 ──┐  ┌─────────────────────────────┐
        └─│ DE-CORRELATE GROUPS OF CHANNELS│
          │   USING DERIVED ICC VALUES    │
          └─────────────────────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 09848877 B
- US 10045458 B
- US 31156501 P
- US 10155437 B
- US 10246570 B
- US 10815591 B
- US 10936464 B
- US 10762100 B
- US 11006492 B
- US 11006XXX A
- WO 2004049309 A
- WO 2005069274 A1
- US 15543702 A
- US 76210004 A

**Non-patent literature cited in the description**

- **F. BAUMGARTE ; C. FALLER.** Binaural Cue Coding - Part I: Psychoacoustic fundamentals and design principles. *IEEE Trans. on Speech and Audio Proc.,* November 2003, vol. 11 (6
- **C. FALLER ; F. BAUMGARTE.** Binaural Cue Coding - Part II: Schemes and applications. *IEEE Trans. on Speech and Audio Proc.,* November 2003, vol. 11 (6
- **C. FALLER.** Coding of spatial audio compatible with different playback formats. *Preprint 117th Conv. Aud. Eng. Soc.,* October 2004
- **J. BLAUERT.** The Psychophysics of Human Sound Localization. MIT Press, 1983
- **D.R. BEGAULT.** 3-D Sound for Virtual Reality and Multimedia. Academic Press, 1994
- Parametric multi-channel audio coding: Synthesis of coherence cues. **C. FALLER.** IEEE Trans. on Speech and Audio Proc. 2003
- **E. SCHUIJERS ; W. OOMEN ; B. DEN BRINKER ; J. BREEBAART.** Advances in parametric coding for high-quality audio. *Preprint 114th Conv. Aud. Eng. Soc.,* March 2003
- **J. ENGDEGARD ; H. PURNHAGEN ; J. RODEN ; L. LILJERYD.** Synthetic ambience in parametric stereo coding. *Preprint 117th Conv. Aud. Eng. Soc.,* May 2004